# EUROPEAN PATENT SPECIFICATION

(11) **EP 2 720 063 B1**
(45) Date of publication and mention of the grant of the patent: **05.02.2020**
(21) Application number: 12188306.0
(22) Date of filing: 12.10.2012
(51) Int. Cl.: G01R 35/04

(54) **Automatic calibration of energy meter central unit**
Automatische Kalibrierung eines zentralen Energiemessgeràtes
Étalonnage automatique de l'unité centrale de compteur d'énergie

(43) Date of publication of application: 16.04.2014
(73) Proprietor: ALSTOM Transport Technologies, 93400 Saint-Ouen (FR)
(72) Inventor: Gioino, Mauro, 20099 Sesto San Giovanni (MI) (IT)
(74) Representative: Karaghiosoff, Giorgio Alessandro

(56) References cited:
- EP-A1- 2 177 926
- EP-A1- 2 343 561
- WO-A2-97/21106
- DE-C1- 19 526 723
- US-A1- 2012 191 395
- US-B1- 6 735 535
- ANONYMOUS: "LEM: Railway Current & Voltage Transducers", , 2007, pages 1-44, XP002695768, Internet Retrieved from the Internet: URL:http://www.amds4.com.br/web/img/CH2610 1_E%282%29.pdf [retrieved on 2013-04-18]

## Description

The invention relates to an energy meter unit with self calibration functions according to claim 1, a method for carrying out auto calibration in an energy meter according to claim 13.

In the field of railway or the like, the energy consumption of the trains has to be very precisely measured. The main criteria for this kind of measurements are set for example for Europe by the normative EN50463, imposing periodical accuracy verification on analogical input channels in Energy Meter Central Units.

Current Energy meters are able to carry out self calibration functions but during execution of these self calibration functions the monitoring of the power consumption by the energy meter is interrupted and can be restarted after the self calibration proceeding has been terminated.

Usually the main way of carrying out self calibration consists in providing a reference signal with known parameters for testing the measuring channels and comparing the measured parameters of the reference signals with the known, nominal ones. From the comparison a calibration adjustment can be carried out in several different ways. Alternatively in some energy meters there is provided in the energy meter a first and a second reference electric energy measuring unit. The energy value measured by the two measuring units is compared and if a difference is determined a calibration adjustment is carried out on the output of the first measuring unit. This configuration needs two measuring units and the reference measuring unit has to be constantly monitored relatively to its accuracy for being a reliable reference measuring unit for the calibration of the first energy measuring unit.

Known energy meters able to carry out some sort of self calibration are known for example from the documents EP2343561, US6815942, WO97/21106, US6735535 and DE19526723 upon which the preamble of claim 1 is based. The energy meters disclosed in these documents do not overcome the problem of interrupting the energy measurement during the calibration process.

The aim of the present invention is to provide for an energy meter unit with self calibration functions, which energy meter is able to carry out the calibration procedure without any interruption of measuring on going.

A further object of the present invention is to define a specific calibration procedure allowing to avoid interruption of the energy measurements and to extend the calibration period set by the regulations.

Still a further object the present invention aims to provide for an energy meter that allows to limit the number of components contributing to stability.

In first instance the present invention achieves the above mentioned aims by means of an energy meter unit with self calibration functions, comprising:
At least one first and one second AC or DC current measuring channel for measuring the current flowing in a AC or DC power feeding line;
At least one first and one second AC or DC voltage measuring channel for measuring the voltage in the said AC or DC power feeding line;
A processing unit having one input for each of the said current and voltage measuring channels;
The processing unit determining the electric power consumption in the power feeding line from the measured current and voltage values and
Means for testing the calibration of the said measuring channels and
Means for carrying out a calibration of the said measuring channels as a function of the results of the calibration test;

Each channel being provided with switching means for cyclically switching each of the said first and second current measuring channels and the said first and second voltage measuring channels alternatively to the power feeding line and to the means for carrying out the calibration test and the calibration of the said channels, thereby carrying out the current and voltage measurements in the power feeding line and the calibration alternatively with one of the said first and second current measuring channels and with one of the said first and second voltage measuring channels.

The new calibration procedure achieving the aims of avoiding interruption of the on going power measurements can so be defined basing on the measuring channel redundancy.

Compared to prior art solution, each analogical acquisition channel is doubled in order to permit measurements on a channel and calibration on the other channel in the same time.

One example of specific calibration procedure may provide for example that periodically (e.g. 5 minutes) the first and second channels for measuring the current and the voltage are exchanged in order to get the measurements from the more recent calibrated channel, without any interruption in the energy calculation and for carry out the calibration test and adjustments on the other measuring channel of the said two channels.

According to a further feature of the present invention, the switching means connect each of the first and second AC and/or DC current and AC and/or DC voltage measuring channel to the power feeding line and to a source of reference signals for the calibration test.

Thus based on redundancy and independent references the device is able to auto-detect the "out of calibration" status.

Different ways of controlling the switching means are possible. For example the switching means can be driven by a control unit which is driven by the processing unit or the switching means can be driven by the said processing unit directly.

In one embodiment of the present invention there are provided a first and second measuring channel for the AC currents, a first and second measuring channel for the DC currents, a first and second measuring channel for the AC voltages and a first and second measuring channel for the DC voltages.

The reference signals for carrying out the calibration test and the calibration of each channel are at least one, preferably two or more different signals having predetermined reference voltages and each switching means has one input for each reference signal and one input for the power feeding line which can be alternatively switched to one of the said first and second AC and/or DC current and voltage measuring channels.

According to one way of carrying out the calibration test, the calibration test means determines the measured voltages of the said reference signals by the measuring channel respectively switched to the said reference signal and compares the said measured voltages of the reference signals with the nominal voltage values of the reference signals.

According to one preferred way of carrying out the calibration adjustments, the calibration means determines correction parameters of the said measurement channel as a function of the result of the said comparison.

In one preferred way of carrying out the calibration test three different reference signals are provided having different reference voltages and having different functions for the calibration test: one for determining the offset of the measuring channel, and the other two for determining the gain factor of the measuring channel.

According to this for each measuring channel the calibration test means determine an offset correction parameter from the difference of the measured offset reference signal and the nominal offset reference signal and means for determining a gain correction parameter from the comparison between the measured gain reference signals and the nominal gain reference signals, each channel being provided with calibration means comprising an adder which adds the offset correction parameter to the measured values by the said channel and a variable gain amplifier which has an input for feeding the gain correction parameter and thus controlling the setting of the gain of the said amplifier.

According to an improvement a further input channel for a further reference signal having a sine wave waveform and a reference frequency for determining the current and voltage measurements phase shift and compensate the said phase shift.

The ratio between the reactive and active power measured on the two calibration channels represents the phase shift to be compensated.

Also in this case the phase shift compensation on the signals can be carried out digitally by the processing unit on the sampled signals.

In one preferred embodiment the offset reference signal is a signal having 0 volt and the gain reference signals being signals having a identical voltage value respectively positive and negative.

According to an embodiment of the present invention the calibration test means and the calibration means are at least partly formed by a processing unit, preferably the processing unit processing the measurement signals in order to calculate and store the energy measurements.

An executable calibration test and calibration program being loaded and executed by the said processing unit the said program providing the processing unit to carry out the functions of determining the offset and gain correction parameters. The processing unit carries out the steps of adding the offset correction parameter and of multiplying the gain correction parameter to the measure signals and in one embodiment the said steps are performed directly in digital way on the single acquired sample.

Thus the present invention also provides for a method for carrying out auto calibration in an energy meter which method comprises a combination or sub combination of one or more of the above mentioned steps for testing the measuring channels and determining the calibration adjustments of the said channels using two or more reference signals for determining two or more calibration adjustment parameters.

Further improvements of the said method consist in the fact that each measuring channel is doubled and each of this two measuring channels is alternatively switched to the line in which the energy consumption has to be measured and to one of the reference signals, so that alternatively one of the two measuring channels is submitted to the calibration test and the other is functional for the energy measurement.

According to one embodiment one reference signal is for determining an additive calibration adjustment parameter to the measured signals of a channel and the other for determining a multiplicative calibration adjustment parameter of the measured signal of a channel.

The additive calibration adjusting parameter can be determined by the difference of the voltage measures of a first reference signal having a predetermined reference voltage with the predetermined nominal value of the said reference voltage and this difference is added to the signals measured by the corresponding channel and the multiplicative calibration adjusting parameter is determined by the ratio of the difference between the measured voltage values of two further reference signals, preferably having same voltage but different polarity, to the difference of the nominal values of the said reference voltages, while the said calibration adjustment parameter is applied to the signals measured by the corresponding channel as the gain of the amplification of the measured signal.

Further reference signal could be provided which is a 50Hz signal for the phase shift compensation.

The invention still relates to a method for operating an energy meter according to one or more of the claimed features of the energy meter disclosed above and in the claims 1 to 14 and which method comprises one or more of the combination of steps claimed in claim 15 and in the above description .

Thanks to the calibration method adopted, the influence factors on the energy measurement are reduced to the shunt resistor and to the voltage reference: using a very high accuracy resistor the limit during the life time is the stability of the voltage reference which can be maintained within very low values.

According to further steps of carrying out calibration the switching of each first and second measuring channel alternatively to the line to be monitored and to the reference signals for carrying out calibration test is executed by first switching both the said first and said second measuring channels to the line to be monitored for a certain period of time and then switching one of the said first and second channels to the reference signals for carrying out the calibration test and the calibration according to the present invention.

This way of carrying out the switching allows to have the two channels in a stable balanced condition.

Obviously the switching means has to be configured in such a way as to allow such kind of switching steps.

According to still another feature the calibration means or the calibration test means in which ever way these means are configured has a memory for a maximum difference value between the measured parameters of at least one or all the reference signals and the nominal (ideal or theoretical) parameters which maximum difference has a function of a threshold. If the difference value between the measured parameters of at least one or all the reference signals and the nominal (ideal or theoretical) parameters exceed the said threshold, then the measuring channel is declared as non functional or "failure" and the calibration is not carried out on that channel. A corresponding indication that a channel is declared non functional is generated. The indication may be of any kind.

Thanks to the above features, compared to prior art solutions, the present invention allows to extend the calibration period from 1÷2 years to 10÷20 years. Moreover, with the autodetection the calibration period is not fixed to a pre-defined time but defined by the device itself, with a great benefit in preventive maintenance costs.

Indeed it is possible to determine by the calibration test and the determination of the calibration adjustment parameters if an adjustment exceeds a certain threshold thereby becoming difficult or impossible to calibrate correctly the corresponding channel.

According to one preferred embodiment the present invention provides for an energy meter according to one or more of the preceding claim which energy meter comprises:
Four analogical input for measuring respectively a AC current a DC current a AC voltage and a DC voltage in a power feeding line, each input being connected in series to a current/voltage converter and to the input of a multiplexer, the multiplexer having one or more inputs for respectively one of one or more reference signals, the multiplexer having two outputs each one connected to a measuring channel, each measuring channel comprising in series a LPF filter and a differential amplifier which output is connected to the input of a channel of respectively one of two AD converters which outputs are connected to one input port of a digital processing unit,
The said digital processing unit having a memory for the measured data and in the said digital processing unit being programmed in such a way as to carry out calculating the power consumption from the measured current and voltage values in the power line, carrying out calibration tests on the measuring channels and carrying out the calibration of the said measuring channels;
The said processing unit generating driving signals for the multiplexers .

In relation to the features of the present invention it has also to be noticed that the redundancies of the measuring channels permit to increase the mission reliability, even if without auto-calibration features.

According to a further feature of the present invention, means are provided for validating the reliability of the calibration test. The reliability of the calibration test depends on the stability and reliability of the characteristic parameter of the reference signals injected in the channel to be tested, which characteristic parameter is the voltage of the reference signals.

According to the present invention at least two or more reference signals are generated by independent sources and are injected alternatively and in sequence in the channel to be tested. Each of the at least two reference signals is used for determining a calibration adjustment parameter of a set of two or more calibration parameters and each adjustment parameter of the said set is used for defining a characteristic curve according to a predetermined function. The characteristic curve determined as the function of the said set of calibration adjustment parameters is compared to the characteristic curve determined with the other set of calibration adjustment parameters and if the difference between the two characteristic curve exceeds a certain threshold the calibration test is considered not reliable.

The above method is based on the fact that when the at least two reference signals are provided by two completely independent sources, it is highly improbable that both of the said at least two reference signals are not correct or faulty and also that the drift for both the said at least two reference signals is of the same order.

As a further improvement the present invention provides for a method for carrying out a test to validate the reliability of the self calibration procedure of an electric energy meter having at least a couple of measuring channels, which method comprises the steps of:
Generating at least two independent reference signals each one having a predetermined reference parameter, preferably its voltage which is different from the other;
Injecting each of the said reference signals into a measuring channel of the energy meter;
Acquiring the measured reference parameter and;
Determining at least two different calibration adjustment parameters according to two different functions from the said measured reference parameter and the predetermined value of the said reference parameters;
Applying the said calibration adjustment parameters to the corresponding channel;
Repeating the said steps for each measuring channel;
Considering the calibration reliable only if the difference between the two sets of calibration parameters remains within a certain defined threshold.

When the difference between the two sets of calibration parameters exceeds a certain defined threshold, the calibration is considered non reliable and a warning alarm is generated and an external adjustment is suggested.

The invention also is directed to an energy meter comprising means for carrying out a test to validate the reliability of the self calibration procedure, the said means consisting in:
One independent source dedicated to provide one of at least two independent reference signals each one having a predetermined reference parameter, preferably its voltage which is different from the other;
Switching means for injecting each of the said reference signals into an energy measuring channel of the energy meter;
Means for acquiring and saving the measured reference parameter of the said reference signals and;
Processing means for determining at least two different calibration adjustment parameters according to two different functions from the said measured reference parameter and the predetermined value of the said reference parameters;
Means for applying the said calibration adjustment parameters to the corresponding measuring channel;
Means for generating a fault alarm or an alarm for an external adjustment when the difference between the two sets of calibration parameters exceeds a certain predefined threshold.

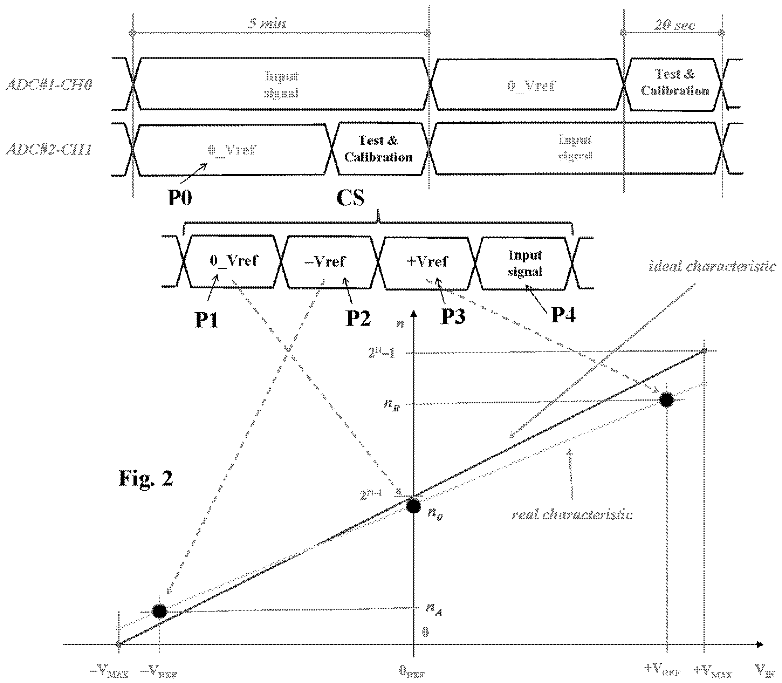

As it will appear more clearly from the following detailed description the preferred embodiment, the reference signals are preferably three reference signals each one having a different voltage. And one of which is a 0Volt reference signal for determining the off set of the measuring channel and the other two are reference signals having different voltage values for determining the gain characteristic of the measuring channel, the characteristic curve being a straight line. An example of the difference between real and ideal straight lines representing the real and ideal characteristic curves of a channel is illustrated in the diagram of figure 2.

Further improvements of the energy meter and of the method for carrying out energy measurements according to the present invention are disclosed in the dependent claims.

The invention and the related advantages are disclosed with more detail in the following description of an embodiment and in the annexed drawings in which:
Fig. 1 shows a scheme of the said exemplary embodiment of the energy meter with the details of a multiplexer.
Figure 2 shows a scheme explaining the calibration test phase which is carried out alternatively on each first and second measuring channel of the AC and DC current and Voltage measuring channels and the relating ideal and real characteristic curved in the form of straight lines from the comparison of which a measure of the reliability of the calibration test can be determined.

The energy meter according to a preferred embodiment of the present invention, comprises four double measuring channels globally indicated by 1, each double channel consists in two independent measuring channels 101 and 102 which are connected each one to an input of a processing unit 2. The processing unit, preferably a digital signal processor reads the measured data and as a first task calculates the energy consumption. Electric energy consumption is calculated in W/h or kW/h. Therefore measuring energy consumption in a power feeding line needs to acquire the measurements of the voltage and current value in the said power feeding line.

In a basic configuration the energy meter could be provided with only two double measuring channels 1. One of which for acquiring the measured values of an AC or DC current and the other double channel for acquiring the measured values of an AC or DC voltage in the power feeding line. In this minimum configuration a first and second measuring channel 101, 102 for the AC or DC current and a first and second measuring channel for the AC or DC voltage is present in the energy meter.

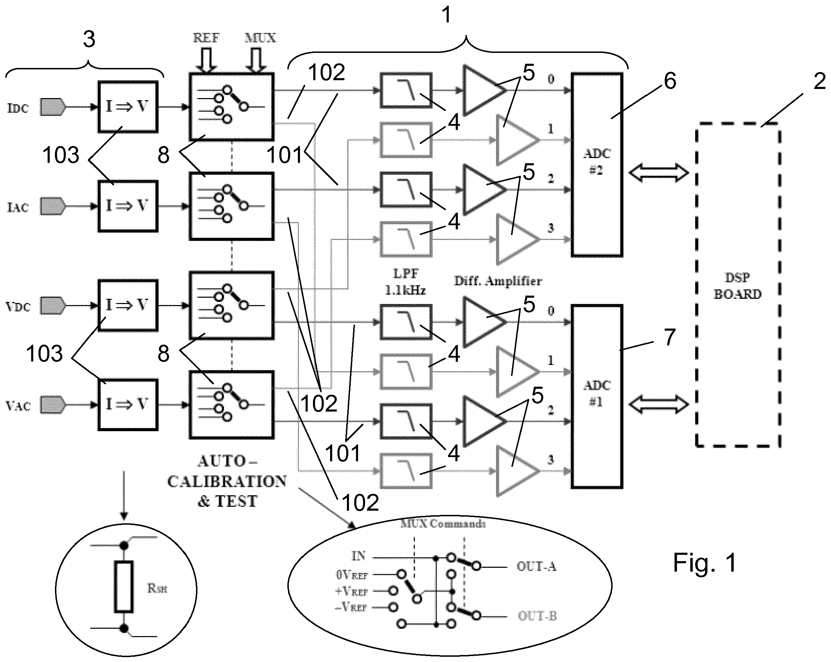

A more complete configuration is provided of double measuring channels 1, i.e. consisting in a first and second measuring channel for the AC and DC currents and voltages, as it is the case of the example in figure 1.

Furthermore the measures of voltage and currents in a power feeding line are all transformed in a voltage measure by a contact or input interface 3 of the measuring channels to the power feeding line comprising a current/voltage converter 103. Normally this converter 103 is a high precision resistor as indicated by the detail in figure 1.

Each channel 101, 102 comprises in series between its input and its output an LPF filter 4 an amplifier 5, preferably a differential amplifier and an Analog/digital converter which output is connected to an input port of the processing unit 2.

In the present embodiment of the figure the eight AD converters are formed by two A/D converters 6, 7 each one having four independent A/D conversion channels whose outputs are connected to a port of the processing unit 2. This can be achieved by dedicated input ports or by a communication protocol of the data strings generated by the A/D converter which allows indentifying univoquely the data corresponding to each separate channel of the A/D converter and thus of the measured values by each corresponding measuring channel.

The four A/D channels of each A/D converter 6, 7 are identified by the suffix 0,1, 2,and 3.

The advantage of the two independent A/D converters is the simultaneous acquisition of current and voltage samples of each couple of measured signals.

The energy meter unit furthermore comprises for the first and second channels 101, 102 of each double measuring channel 1 a switching means which in the present example is a multiplexer 8. Each multiplexer 8 has one input indicated as IN which is connected to the input or connection interface 3 for each double measuring channel 1. In the figure there are four interfaces 3 respectively for the measurement of the DC current and voltage identified by IDC and VDC and for the AC current and voltage indentified by IAC and VAC.

Each multiplexer 8 has further inputs for at least one, or for more than one reference signal. In the present exemplary embodiment there are three further inputs for three different reference signals each one having as a reference parameter a certain predetermined reference voltage value. One indicated by 0V_{REF} is a 0 voltage reference signal and is used to carry out the calibration test relatively to offset drifts of the measuring channels. The other two inputs are for two more reference signals having a certain non zero, predetermined voltage. The two reference signals have different voltages which are preferably of identical value but inverted polarity so to be symmetric relatively to the 0volt reference voltage. In the present example the two inputs of these two reference signals are indicated respectively by +V_{REF} and -V_{REF}.

Each multiplexer 8 has two outputs indicated by out-A and out-B which are respectively connected to the first and to the second measuring channel 101 and 102 of each double measuring channel 1.

From the structure of the switching contacts illustrated in the detail of figure 1 it becomes clear that for each double measuring channel 1, the first and second measuring channels 101 and 102 can be connected alternatively or together to the input IN of the multiplexer 8 and thus to the interface 3 with the power feeding line to be monitored and the first and second measuring channels 101 and 102 can be connected alternatively one to the other to one of the reference signals 0V_{REF,} +V_{REF} and -V_{REF.}

Each multiplexer 8 is driven by a control signal generated by a control unit which can be a separate control unit driven by the processing unit 2 or which control unit can be the processing unit 2 itself in which a multiplexer control program is loaded and executed. These two options are not illustrated in the figure since they are obvious for the skilled person. Same applies for the fact that there must be a synchronism of switching each of the two channels 101, 102 of the double channels 1 in order to feed to the processing unit 2 always a voltage and a current value which are needed for computing the electric power in the power feeding line.

As a further improvement which is not mandatory for the present invention, but which adds further advantages, the embodiment of figure 1 shows that all the first channels 101 and all the second channels 102 of each double measuring channels are connected respectively only to the first A/D converter 6 and to the second A/D converter 7. This kind of crossing of the two channels 101 and 102 to the first and second channels allows to exploit the redundant configuration of the energy meter according to the present invention in order to still allow energy consumption measurements if one A/D converter fails or is damaged.

As it appears further from the figure the first and second channel 101, 102 of each double measuring channel 1 are not connected to the same channel 0, 1, 2, or 3 of the two A/D converters, but the first channel 101 is connected to a certain channel of the first A/D converter 6 and the second channel 102 is connected to a different channel of the second A/D converter as the one to which the first channel 101 is connected to the first A/D converter 6. This allows to maintain aligned the sampling of the two ADC involving the couples 00,11,22,33 representing AC and DC voltage and current correlated signals.

As it appears clearly from the above configuration of the structure of the energy meter and thanks to the provision of double measuring channel for each current and voltage measure in the power feeding line it is possible to carry out the energy measurement alternatively using one of the two measuring channels 101, 102 of each double measuring channel 2, while the other measuring channel 101, 102 of each double measuring channel 2 can be subjected to calibration test and calibration adjustment.

In the present embodiment the calibration means for testing and adjusting calibration of the measuring channels 101, 102 are formed by the reference signals and obviously by the mean for generating such signals, which is internal to the energy mete, by a differential amplifier 5 and by the processing unit 2 which in the present embodiment is able to execute a calibration test and calibration adjustment program which has been loaded in its memory.

This particular arrangement allows to easily implement or modify the calibration testing and adjusting procedure, avoiding as far as possible hardware modifications in the energy meter.

A particular way of carry out calibration according to the present invention provides testing and adjustment of two calibration parameters of each measuring channel 101, 102 which are the 0Volt offset of the measuring channel and the gain of each channel. The adjustment is carried out by determining an additive calibration adjustment consisting in an offset adjustment parameter to be added to the measured voltage values by the corresponding measuring channel and by determining a multiplicative calibration adjustment consisting a gain adjustment parameter to be multiplied with the voltage values measured by the corresponding measuring channel.

The offset adjustment parameter is added to the voltage measures by a measuring channel by the processing unit 2. Similarly the gain adjustment parameter is applied as multiplicative factor to the voltage measures by a measuring channel by the processing unit 2. The said functions are carried out digitally on the sampled signals received by the processing unit 2. Of course the processing unit 2 is provided with dedicated memories or memories areas such as a RAM for saving the measured data and the adjustment parameters. Since several configuration of processing unit 2 can be chosen by the skilled person from a rich spectrum of processing units available in the state of the art and each processing unit being able to carry out the above described functions, the structure of the processing unit is not disclosed in detail.

In the following the way of operation of the energy meter according to the present example and the way of testing and calibration the measuring channels are described with more detail.

Acquisition of 8 input stages using the two A/D converter:
AC Current signal, A/D conversion 16bit, 16Ksps sample rate on the two channels 101, 102 of a dual channels measuring channel
DC Current signal, A/D conversion 16bit, 16Ksps sample rate on the two channels 101, 102 of a dual channels measuring channel
AC Voltage signal, A/D conversion 16bit, 16Ksps sample rate on the two channels 101, 102 of a dual channels measuring channel
DC Voltage signal, A/D conversion 16bit, 16Ksps sample rate on the two channels 101, 102 of a dual channels measuring channel

Full scale of 16bit acquisition shall be adapted to shunt resistor used for input signal measurement:
As an example the following data may apply

| Max. input signal [mA] | Shunt resistor [Ω] | Max. Equivalent FS [Count] (signed) | Full Scale [Count] (signed) |
|---|---|---|---|
| ±50 | 40.2 | ±29273 | - 32767 ÷ 32768 |

### Outputs: data converted (counts) available for calculation function (with calibration function included)

### Calibration

### Inputs: data converted available for calculation function

Calibration procedure is implemented in order to guarantee the accuracy on energy measurement. Switching between channels is implemented with multiplexer management in order to guarantee continuous acquisition of input signals: one channel measuring the input signal, the second in calibration.

Each configurable time (TCALIBRATION) calibration procedure execute following steps:
1) For each couple of channels, one channel shall measure the input signal while the other measures reference voltage (0V), that is the offset of the channel
2) For each couple of channels, one channel shall measure the input signal while the other measures -V_{REF} reference voltage (-2.048V)
3) For each couple of channels, one channel shall measure the input signal while the other measures +V_{REF} reference voltage (+2.048V)
4) Acquired reference values shall be stored in a table containing the offset (NOFS) and the linear gain (GACQ) which is calculated on the two reference voltages -V_{REF} and +V_{REF} (±2.048V).
5) At first both channels shall be connected to physical input channel (both channels measure input signal)
6) After a stabilization time (TSTAB of 5 sec), correction shall be implemented on channel under calibration.
7) Afterwards calibrated channel shall be used as measurement channel for energy calculation, the other shall not be used (fixed to 0V_{REF}).

Run-time calibration shall be executed according to following acquisition stage configuration:

| Signal/measuring channel | ADC | Channel of the ADC | Main/Dual |
|---|---|---|---|
| VDC/101 | ADC2 | Ch1 | Main |
| VDC/102 | ADC1 | Ch0 | Dual |
| IDC/101 | ADC2 | Ch0 | Main |
| IDC/102 | ADC1 | Ch1 | Dual |
| VAC/101 | ADC2 | Ch3 | Main |
| VAC/102 | ADC1 | Ch2 | Dual |
| IAC/101 | ADC2 | Ch2 | Main |
| IAC/102 | ADC1 | Ch3 | Dual |

Each programmable time (T_CALIBRATION) the calibration procedure will be applied switching alternatively the main and dual channels

At the end calibration result shall be flagged (Passed or Failed).

The above described calibration test steps are also explained with a scheme of figure 2.

The calibration sequence CS for each channel comprises as disclosed above three phases:
one phase P1 in which the 0V_{REF} signal is fed to the channel;
a second phase P2 in which the -V_{REF} reference voltage signal is fed to the said measuring channel and
a third phase P3 in which the +V_{REF} reference voltage signal is fed to the said measuring channel.

Each of the said phases P1 to P3 has a duration of approximately some seconds, preferably 5 seconds.

A fourth phase P4 being provided after the third phase P3 which is the switching phase during which the first channel and the second channel are connected together to the same input signal in order to provide an instantaneous switching without unwanted transients This fourths switching phase has also a duration of 5 seconds. After this intermediate step one of the two cannels (the one which previously was connected to the line to be monitored) will be connected to the reference signals for carrying out the calibration test.

The calibration sequence CS id performed in the final 20s of the T_CALIBRATION period (typically 5 minutes). The remaining time (P0 in Fig.2) is a sort of stand-by for the channel under calibration during which the channel itself is maintained connected to 0 Vref.

The scheme of figure 2 combines also a graph of the real (measured) characteristic curves of a channel during calibration and of the corresponding ideal characteristic curve for a measuring channel.

The dots indicated by n₀ n_{A} and n_{B} are the measured values when the channel is connected respectively to the 0V_{REF}, -V_{REF}, and +V_{REF} reference signals.

According to a further feature of the present invention, each value acquired by the channel (nA, *n*B, *n*0) is compared with the ideal value. If the difference exceed a defined threshold the channel is declared "failure" and the calibration will be not carried out. This situation may be signalled in every desired way in order to carry out the necessary steps.

According to a possible improvement a further reference signal may be provided for calibration. This reference signal may be used to calibrate also the phase shift. In this improvement, further to the +Vref, -Vref, 0Vref reference signals a fourth calibration signal made by a 50Hz sine wave may be provided. The amplitude of the signal is not relevant. From the active and reactive power measurements it is possible to compensate the phase shift of current and voltage measuring channels 101, 102 which is mainly due to LPF filters 4.

The need of a fourth calibration reference signal for compensating phase shift may be avoided by improving the accuracy components in LPF filter. With respect to the embodiment providing the reference signal for compensating the phase shift this alternative solution allows to spare space in the A/D board.

As it appears from figure 2, the reference signals 0Vref, -Vref and +Vref can be used for determining a characteristic curve of the channel under test which in the present example is a straight line.

Using the measured values of oVref and -Vref and +Vref, for determining offset and gain of the channel, the said parameters can be used for drafting a real characteristic curve which can be compared to the ideal one. If each of the said reference voltages or at least two of the said reference voltages are generated by independent sources it will be highly improbable that if a fault occurs in the source or the reference voltage is not correct, the same error is present also for all the reference voltages so that the resulting real reference curve will be different and not parallel to the ideal characteristic curve. A threshold may be set for this difference so that if the said threshold is exceeded the channel can be set as faulty and an alarm or other kind of signals may be generated for carrying out the necessary maintenance steps.

Thus the energy meter according to the invention also allows for testing the reliability of the calibration test due to reference signals faults such as aberration or drifts.

## Claims

1. Energy meter unit with self calibration functions, comprising:
At least one first and one second AC or DC current measuring channel (101, 102), defined as one AC or DC double current measuring channel (1), for measuring the current flowing in a AC or DC power feeding line;
At least one first and one second AC or DC voltage measuring channel (101, 102), defined as one AC or DC double voltage measuring channel (1), for measuring the voltage in the said AC or DC power feeding line;
A processing unit (2) having one input for each of the said current and voltage measuring channels (101, 102);
The processing unit (2) determining the electric power consumption in the power feeding line from the measured current and voltage values and
Means (2, 8) for testing the calibration of the said measuring channels and
Means (2) for carrying out a calibration of the said measuring channels as a function of the results of the calibration test,
**characterized in that**
Each measuring channel (101, 102) is provided with switching means (8) for cyclically switching each of the said first and second current measuring channels (101, 102) and the said first and second voltage measuring channels (101, 102) alternatively to the power feeding line and to the means for carrying out the calibration test and the calibration of the said channels, thereby being able to carry out the measurements alternatively using one of the two measuring channels (101, 102) of each double measuring channel (1), while the other measuring channel (102, 101) of each double measuring channel (1) can be subjected for calibration.

2. Energy meter according to claim 1, in which there are provided a first and a second AC current measuring channel (101, 102), a first and a second DC current measuring channel (101, 102);
A first and a second AC voltage measuring channel (101, 102) and a first and a second DC voltage measuring channel (101, 102), each channel having a switching means (8) for cyclically switching the said first and the said second measuring channel (101, 102) alternatively to the power feeding line and to the means for carrying out the calibration test and the means for calibrating the said channels, thereby carrying out the current and voltage measurements and the calibration alternatively with one of the said first and second current measuring channels (101, 102) and with one of the said first and second voltage measurements channels (101, 102).

3. Energy meter according to claim 1 or 2, in which the processing unit (2) is a digital signal processing unit and each measuring channel is connected through a analog to digital signal converter (6, 7) to one of the input of the digital signal processing unit (2).

4. Energy meter according to one or more of the preceding claims, in which the switching means (8) connects each of the first and second AC and/or DC current and AC and/or DC voltage measuring channel (101, 102) alternatively to the power feeding line and to a source of reference signals for the calibration test.

5. Energy meter according to claim 4 in which two analog to digital signal converters (6, 7) are provided each one connected to one input of the processing unit (2) and each one having four conversion channels, the first measuring channels (101) respectively for the AC and DC currents and the AC and DC voltages being connected to the conversion channels of a first digital converter (6) while the second measuring channels (102) for the AC and DC current and voltage being connected to the conversion channels of a second digital converter (7).

6. Energy meter according to one or more of the preceding claims in which each switching means (8) has at least two inputs which can be alternatively switched to one of the said first and second AC and/or DC current and voltage measuring channel (101, 102) and of which inputs one input is connected to the power feeding line, and the at least one further input to a source of at least one reference signal, the means for testing the calibration determining a measured reference signal by the measuring channel (101, 102) respectively switched to the said source of reference signal and comparing the said measured reference signal with the nominal reference signal and the means for carrying out the calibration determining a correction parameters of the said measurement channel (101, 102) as a function of the result of the said comparison.

7. Energy meter according to claim 6 in which each switching means (8) has at least four inputs for alternatively connecting the corresponding first and second measurement channel (101, 102) to the power feeding line and to three different reference signals (OVref, -Vref, +Vref) one for determining the offset of the measuring channel, and the other two for determining the gain factor of the measuring channel, the means for carrying out the calibration comprising comparison means for determining an offset correction parameter from the difference of the measured offset reference signal and the nominal offset reference signal and means for determining a gain correction parameter from the comparison between the measured gain reference signals and the nominal gain reference signals, each channel (101, 102) being provided with means for carrying out the calibration comprising an adder which adds the offset correction parameter to the measured values by the said channel.

8. Energy meter according to claims 6 or 7 in which the switching means (8) have a further input channel for a further reference signal having a sine wave waveform and a reference frequency for determining the current and voltage measurements phase shift and compensate the said phase shift.

9. Energy meter according to one or more of the preceding claims 4 to 8 in which the measuring channels (101, 102) measure voltage values, each measuring channel being connected to the power feeding line by a current/voltage converter (103), the reference signals (0Vref, -Vref, +Vref) being signals having a predetermined voltage reference value.

10. Energy meter according to claim 7 and 9 in which the reference signal for determining the offset is a signal having 0 volt and the reference signals for determining the gain factor being signals having different voltage values, that could be also identical, respectively positive and negative.

11. Energy meter according to one or more of the preceding claims 7 to 10 in which
each switching means (8) is a multiplexer;
each measuring channel (101, 102) is provided with a LPF filter (4) having the input connected to the output of a corresponding multiplexer (8) and an output connected to a differential amplifier (5) which output is connected to a channel of respectively a first and a second of the said analog to digital converter (6, 7) each analog to digital converter being connected to the input of a processing unit (2), the said processing unit being provided with means for generating a multiplexer control signal for driving the multiplexers (8), and the means for carrying out the calibration being formed by the said processing unit (2) comprising means for calculating the offset correction parameters and the gain correction parameters of each measuring channels (101, 102) and the said adder for adding the offset correction parameter to the measured voltage value of each measuring channel (101, 102) and means for applying the said gain correction parameters as a multiplicative factor to the said measured voltage value.

12. Energy meter according to claim 11 in which the said means for carrying out the calibration are an executable program loaded and executed by the said processing unit (2).

13. A method for carrying out auto calibration in an energy meter according to one or more of the preceding claims in which
Each of the first AC and/or DC current and AC and/or DC voltage measuring channels and each of the second AC and/or DC current and AC and/or DC voltage measuring channels are alternatively switched to the line in which the energy consumption has to be measured and to one or more reference signals, so that alternatively one of the said first and second measuring channels is submitted to the calibration test and the other of the first and second measuring channels is functional for the energy measurement and in which
The calibration test consisting in the comparison between the reference voltage measured by a measuring channel and a nominal value of the said reference voltage and is carried out a certain number of times in certain time sequence;
one first reference signal being for determining an additive calibration adjustment parameter to the measured signals of a channel;
the said additive calibration adjusting parameter being determined by the difference of the voltage measures of said first reference signal having a predetermined reference voltage with the predetermined nominal value of the said reference voltage,
**characterized in that**
two further reference signals are provided for determining a multiplicative calibration adjustment parameter of the measured signal of a measuring channel, the said multiplicative calibration adjusting parameter being determined by the ratio of the difference between the measured voltage values of the said two further reference signals, preferably having same voltage but different polarity, to the difference of the nominal values of the said reference voltages,
the calibration of each channel being carried out by adding the said additive calibration adjusting parameter to the signals measured by the corresponding channel and by applying the said multiplicative calibration adjustment parameter to the signals measured by the corresponding channel as the gain of the amplification of the measured signal.

14. A method according to claim 13 in which a fourth reference signal is provided for calibration of the phase shift which fourth reference signal being a 50Hz sine wave being alternatively fed to each measuring channel thereby for compensating the phase shift of current and voltage measuring channels by active and reactive power measurements.

15. A method for carrying out a test to validate the reliability of the auto calibration procedure of claim 13 or 14 in an electric energy meter having at least a couple of measuring channels, which method comprises the steps of:
Generating independent reference signals each one having a predetermined reference parameter, preferably its voltage which is different from the other;
Injecting each of the said reference signals into a measuring channel of the energy meter;
Acquiring the measured reference parameter for each of the said reference signals;
calculating at least two different calibration adjustment parameters according to two different functions from the said measured reference parameter of the said reference signals and the predetermined value of the said reference parameters of the said reference signals;
Applying the said calibration adjustment parameters to the corresponding channel;
Repeating the said steps for each measuring channel,
**characterized in that**
the step of generating independent reference signals comprises generating at least three independent reference signals (OVref, -Vref, +Vref), the method further comprising:
determining for each measuring channel a real characteristic curve calculated by applying the said calibration parameters to the said channel and an ideal characteristic curve using the three reference signals (OVref, -Vref, +Vref);
Considering the calibration reliable only if the difference between the real characteristic curve and the ideal characteristic curve of the said channel remains within a defined threshold, otherwise considering the calibration non reliable and generating one or more different alarm signals and/or an external maintenance/adjustment request and/or setting the channel in an inactive state.

## Patentansprüche

1. Energiezählereinheit mit Selbstkalibrierungsfunktionen, umfassend:
mindestens einen ersten und einen zweiten Wechselstrom- oder Gleichstrommesskanal (101, 102), definiert als ein AC- oder DC-Doppelstrommesskanal (1), zum Messen des in einer Wechselstrom- oder Gleichstromversorgungsleitung fließenden Stroms;
mindestens einen ersten und einen zweiten Wechselspannungs- oder Gleichspannungsmesskanal (101, 102), definiert als ein AC- oder DC-Doppelspannungsmesskanal (1), zum Messen der Spannung in der Wechselstrom- oder Gleichstromversorgungsleitung;
eine Verarbeitungseinheit (2) mit einem Eingang für jeden der Strom- und Spannungsmesskanäle (101, 102);
die Verarbeitungseinheit (2) den elektrischen Leistungsverbrauch in der Energieversorgungsleitung aus den gemessenen Strom-und Spannungswerten ermittelt und
Mittel (2, 8) zum Testen der Kalibrierung der Messkanäle und
Mittel (2) zur Durchführung einer Kalibrierung der genannten Messkanäle in Abhängigkeit von den Ergebnissen des Kalibriertests,
**dadurch gekennzeichnet, dass**
jeder Messkanal (101, 102) mit Schaltmitteln (8) zum zyklischen Schalten jedes der ersten und zweiten Strommesskanäle (101, 102) und der ersten und zweiten Spannungsmesskanäle (101, 102) wahlweise zur Energieversorgungsleitung und zu den Mitteln zur Durchführung des Kalibriertests und der Kalibrierung der Kanäle versehen ist, wobei die Messungen wahlweise mit einem der beiden Messkanäle (101, 102) jedes Doppelmesskanals (1) durchführbar sind, während der andere Messkanal (102, 101) jedes Doppelmesskanals (1) einer Kalibrierung unterzogen werden kann.

2. Energiezähler nach Anspruch 1, umfassend einen ersten und einen zweiten Wechselstrommesskanal (101, 102), einen ersten und einen zweiten Gleichstrommesskanal (101, 102); einen ersten und einen zweiten Wechselspannungsmesskanal (101, 102) und einen ersten und einen zweiten Gleichspannungsmesskanal (101, 102), wobei jeder Kanal ein Schaltmittel (8) zum zyklischen Schalten des ersten und des zweiten Messkanals (101, 102) wahlweise zu der Stromversorgungsleitung und zu den Mitteln zur Durchführung des Kalibriertests und zu den Mitteln zum Kalibrieren der Kanäle, um dadurch die Strom- und Spannungsmessungen und die Kalibrierung wahlweise mit einem der ersten und zweiten Strommesskanäle (101, 102) und mit einem der ersten und zweiten Spannungsmesskanäle (101, 102) auszuführen.

3. Energiezähler nach Anspruch 1 oder 2, bei dem die Verarbeitungseinheit (2) eine digitale Signalverarbeitungseinheit ist und jeder Messkanal über einen Analog-Digital-Signalwandler (6, 7) mit einem der Eingänge der digitalen Signalverarbeitungseinheit (2) verbunden ist.

4. Energiezähler nach einem oder mehreren der vorhergehenden Ansprüche, bei dem das Schaltmittel (8) jeweils den ersten und zweiten Wechsel- und/oder Gleichstrommesskanal und Wechsel- und/oder Gleichspannungsmesskanal (101, 102) wahlweise mit der Stromversorgungsleitung und mit einer Referenzsignalquelle für den Kalibriertest verbindet.

5. Energiezähler nach Anspruch 4, bei dem jeweils zwei Analog-Digital-Signalwandler (6, 7) vorgesehen sind, die jeweils mit einem Eingang der Verarbeitungseinheit (2) verbunden sind und jeweils vier Wandlungskanäle aufweisen, wobei die ersten Messkanäle (101) für die Wechsel- und Gleichströme und die Wechsel- und Gleichspannungen jeweils mit den Wandlungskanälen eines ersten Digitalwandlers (6) verbunden sind, während die zweiten Messkanäle (102) für den Wechsel- und Gleichstrom und die Wechsel- und Gleichspannung mit den Wandlungskanälen eines zweiten Digitalwandlers (7) verbunden sind.

6. Energiezähler nach einem oder mehreren der vorhergehenden Ansprüche, bei dem jedes Schaltmittel (8) wenigstens zwei Eingänge aufweist, die wahlweise auf einen der ersten und zweiten Wechsel- und/oder Gleichstrom- und Wechsel- und/oder Gleichspannungsmesskanäle (101, 102) schaltbar sind und ein Eingang von diesen mit der Stromversorgungsleitung und der mindestens eine weitere Eingang mit einer Quelle für mindestens ein Referenzsignal verbunden ist, wobei die Mittel zum Testen der Kalibrierung ein gemessenes Referenzsignal durch den jeweils auf die Quelle des Referenzsignals geschalteten Messkanal (101, 102) ermitteln und das gemessene Referenzsignal mit dem Soll-Referenzsignal vergleichen und die Mittel zur Durchführung der Kalibrierung in Abhängigkeit von dem Ergebnis des Vergleichs Korrekturparameter des Messkanals (101, 102) ermitteln.

7. Energiezähler nach Anspruch 6, bei dem jedes Schaltmittel (8) wenigstens vier Eingänge aufweist zum wahlweisen Verbinden des entsprechenden ersten und zweiten Messkanals (101, 102) mit der Stromversorgungsleitung und mit drei verschiedenen Referenzsignalen (OVref, -Vref, +Vref), wobei ein Signal zur Bestimmung des Offsets des Messkanals und die anderen zwei zur Bestimmung des Gewinnfaktors des Messkanals vorgesehen sind, wobei die Mittel zur Durchführung der Kalibrierung Vergleichsmittel zur Bestimmung eines Offset-Korrekturparameters aus der Differenz des gemessenen Offset-Referenzsignals und des Soll-Offset-Referenzsignals und Mittel zur Bestimmung eines Gewinnkorrekturparameters aus dem Vergleich zwischen den gemessenen Gewinnreferenzsignalen und den Soll-Gewinnreferenzsignalen umfassen, wobei jeder Kanal (101, 102) mit Mitteln zur Durchführung der Kalibrierung versehen ist, die einen Addierer umfassen, der den Offset-Korrekturparameter durch den genannten Kanal zu den Messwerten addiert.

8. Energiezähler nach Anspruch 6 oder 7, bei dem die Schaltmittel (8) einen weiteren Eingangskanal für ein weiteres Referenzsignal mit einer Sinuswellenform und einer Referenzfrequenz zur Bestimmung der Phasenverschiebung der Strom- und Spannungsmessungen aufweisen und diese Phasenverschiebung kompensieren.

9. Energiezähler nach einem oder mehreren der vorhergehenden Ansprüche 4 bis 8, bei dem die Messkanäle (101, 102) Spannungswerte messen, wobei jeder Messkanal über einen Strom-/Spannungswandler (103) mit der Stromversorgungsleitung verbunden ist, wobei die Referenzsignale (0Vref,-Vref, +Vref) Signale mit einem vorbestimmten Spannungsreferenzwert sind.

10. Energiezähler nach Anspruch 7 und 9, bei dem das Referenzsignal zur Bestimmung des Offsets ein Signal mit 0 Volt ist und die Referenzsignale zur Bestimmung des Gewinnfaktors Signale mit unterschiedlichen Spannungswerten sind, die ebenfalls identisch, jeweils positiv und negativ sein können.

11. Energiezähler nach einem oder mehreren der vorhergehenden Ansprüche 7 bis 10, bei dem jedes Schaltmittel (8) ein Multiplexer ist; jeder Messkanal (101, 102) ein LPF-Filter (4) aufweist, dessen Eingang mit dem Ausgang eines entsprechenden Multiplexers (8) verbunden ist und dessen Ausgang mit einem Differenzverstärker (5) verbunden ist, welcher Ausgang mit einem Kanal jeweils eines ersten und eines zweiten des besagten Analog-Digital-Wandlers (6, 7) verbunden ist, wobei jeder Analog-DigitalWandler mit dem Eingang einer Verarbeitungseinheit (2) verbunden ist, wobei die Verarbeitungseinheit mit Mitteln zum Erzeugen eines Multiplexersteuersignals zum Ansteuern der Multiplexer (8) versehen ist, und wobei die durch die Verarbeitungseinheit (2) gebildete Mittel zur Durchführung der Kalibrierung Mittel zum Berechnen der Offsetkorrekturparameter und der Gewinnkorrekturparameter jedes Messkanals (101, 102) und den Addierer zum Addieren des Offsetkorrekturparameters zu dem gemessenen Spannungswert jedes Messkanals (101, 102) und Mittel zum Anwenden der Gewinnkorrekturparameter als multiplikativen Faktor auf den gemessenen Spannungswert umfassen.

12. Energiezähler nach Anspruch 11, bei dem die Mittel zur Durchführung der Kalibrierung ein ausführbares Programm sind, das von der Verarbeitungseinheit (2) geladen und ausgeführt wird.

13. Verfahren zur Durchführung einer Selbstkalibrierung in einem Energiezähler nach einem oder mehreren der vorhergehenden Ansprüche, bei dem
jeder der ersten Wechsel- und/oder Gleichstrommesskanäle und Wechsel- und/oder Gleichspannungsmesskanäle und jeder der zweiten Wechsel- und/oder Gleichstrommesskanäle und Wechsel- und/oder Gleichspannungsmesskanäle wahlweise auf die Leitung, in der der Energieverbrauch gemessen werden muss, und auf ein oder mehrere Referenzsignale geschaltet werden, so dass wahlweise einer der ersten und zweiten Messkanäle dem Kalibriertest unterworfen wird und der andere der ersten und zweiten Messkanäle für die Energiemessung Funktionsfähig ist und bei dem
der Kalibriertest aus dem Vergleich zwischen der von einem Messkanal gemessenen Referenzspannung und einem Sollwert der genannten Referenzspannung besteht und in bestimmten zeitlichen Abfolgen mehrfach durchgeführt wird;
wobei ein erstes Referenzsignal zur Bestimmung eines additiven Kalibriereinstellungsparameters auf die Messsignale eines Kanals dient;
wobei der additive Kalibriereinstellparameter durch die Differenz der Spannungsmessungen des ersten Referenzsignals mit vorgegebener Referenzspannung mit dem vorgegebenen Sollwert der Referenzspannung bestimmt wird,
**dadurch gekennzeichnet, dass**
zur Bestimmung eines multiplikativen Kalibriereinstellparameters des Messsignals eines Messkanals zwei weitere Referenzsignale vorgesehen sind, wobei der multiplikative Kalibriereinstellparameter durch das Verhältnis der Differenz der gemessenen Spannungswerte der beiden weiteren Referenzsignale, vorzugsweise mit gleicher Spannung aber unterschiedlicher Polarität, zu der Differenz der Sollwerte der Referenzspannungen bestimmt wird,
wobei die Kalibrierung jedes Kanals durch Addieren des additiven Kalibriereinstellungsparameters zu den von dem entsprechenden Kanal gemessenen Signalen und durch Anwenden des multiplikativen Kalibrierungseinstellparameters auf die von dem entsprechenden Kanal gemessenen Signale als Gewinn der Verstärkung des gemessenen Signals durchgeführt wird.

14. Verfahren nach Anspruch 13, bei dem ein viertes Referenzsignal zur Kalibrierung der Phasenverschiebung bereitgestellt wird, wobei das vierte Referenzsignal eine 50Hz Sinuswelle ist, die jedem Messkanal wahlweise zur Kompensation der Phasenverschiebung von Strom- und Spannungsmesskanälen durch Wirkleistungs- und Blindeistungsmessungen zugeführt wird.

15. Verfahren zur Durchführung eines Tests zur Validierung der Zuverlässigkeit des Selbstkalibrierverfahrens nach Anspruch 13 oder 14 in einem elektrischen Energiezähler mit mindestens einem Paar von Messkanälen, wobei das Verfahren die Schritte umfasst:
Erzeugen von unabhängigen Referenzsignalen, die jeweils einen vorbestimmten Referenzparameter aufweisen, deren Spannung vorzugsweise voneinander verschieden sind;
Einspeisen jedes der Referenzsignale in einen Messkanal des Energiezählers; Erfassen des gemessenen Referenzparameters für jedes der Referenzsignale;
Berechnen von zumindest zwei unterschiedlichen Kalibriereinstellungsparametern gemäß zwei unterschiedlichen Funktionen aus dem gemessenen Referenzparameter der Referenzsignale und dem vorbestimmten Wert der Referenzparameter der Referenzsignale;
Anwenden der Kalibriereinstellungsparameter auf den entsprechenden Kanal;
Wiederholen der Schritte für jeden Messkanal,
**dadurch gekennzeichnet, dass**
der Schritt des Erzeugens unabhängiger Referenzsignale das Erzeugen von zumindest drei unabhängigen Referenzsignalen (OVref, -Vref, +Vref) umfasst, wobei das Verfahren ferner umfasst:
Bestimmen für jeden Messkanal einer realen Kennlinie, die durch Anwenden der Kalibrierungsparameter auf den Kanal berechnet wird, und einer idealen Kennlinie unter Verwendung der drei Referenzsignale (OVref, -Vref, +Vref);
Berücksichtigen einer Kalibrierung als zuverlässig nur dann, wenn die Differenz zwischen der realen Kennlinie und der idealen Kennlinie des genannten Kanals innerhalb einer definierten Schwelle bleibt, andernfalls Berücksichtigen der Kalibrierung als nicht zuverlässig und Erzeugen eines oder mehrerer verschiedener Alarmsignale und/oder einer externen Wartungs-/Justageanforderung und/oder Einstellung des Kanals in einem inaktiven Zustand.

## Revendications

1. Unité de compteur d'énergie avec fonctions d'auto-étalonnage, comprenant:
Au moins un premier et un deuxième canal de mesurage de courant alternatif ou continu (101, 102), défini comme un canal de mesurage de courant double alternatif ou continu (1), pour mesurer le courant circulant dans une ligne d'alimentation électrique en courant alternatif ou continu;
Au moins un premier et un deuxième canal de mesurage de tension alternative ou continue (101, 102), défini comme un canal de mesurage de tension double alternative ou continue (1), pour mesurer la tension dans ladite ligne d'alimentation électrique en courant alternatif ou continu;
Une unité de traitement (2) ayant une entrée pour chacun desdits canaux de mesurage de courant et de tension (101, 102);
L'unité de traitement (2) déterminant la consommation d'énergie électrique dans la ligne d'alimentation électrique à partir des valeurs mesurées de courant et de tension, et
Moyens (2, 8) pour tester l'étalonnage desdits canaux de mesurage et
Moyens (2) pour effectuer un étalonnage desdits canaux de mesurage en fonction des résultats du test d'étalonnage,
**caractérisé en ce que**
Chaque canal de mesurage (101, 102) est muni de moyens de commutation (8) pour passer cycliquement chacun desdits premier et deuxième canaux de mesurage de courant (101, 102) et desdits premier et deuxième canaux de mesurage de tension (101, 102) alternativement à la ligne d'alimentation électrique et aux moyens pour effectuer le test d'étalonnage et l'étalonnage desdits canaux, pouvant ainsi effectuer les mesurages en utilisant alternativement un des deux canaux de mesurage (101, 102) de chaque canal de mesurage double (1), alors que l'autre canal de mesurage (102, 101) de chaque canal de mesurage double (1) peut être soumis à l'étalonnage.

2. Compteur d'énergie selon la revendication 1, dans lequel sont prévus un premier et un deuxième canal de mesurage de courant alternatif (101, 102), un premier et un deuxième canal de mesurage de courant continu (101, 102);
Un premier et un deuxième canal de mesurage de tension alternative (101, 102) et un premier et un deuxième canal de mesurage de tension continue (101, 102), chaque canal ayant des moyens de commutation (8) pour passer cycliquement lesdits premier et deuxième canaux de mesurage (101, 102) alternativement à la ligne d'alimentation électrique et aux moyens pour effectuer le test d'étalonnage et aux moyens pour étalonner lesdits canaux, effectuant ainsi les mesurages de courant et tension et l'étalonnage alternativement avec un desdits premier et deuxième canaux de mesurage de courant (101, 102) et avec l'un desdits premier et deuxième canaux de mesurage de tension (101, 102).

3. Compteur d'énergie selon la revendication 1 ou 2, dans lequel l'unité de traitement (2) est une unité de traitement de signaux numériques et chaque canal de mesurage est connecté à une des entrées de l'unité de traitement de signaux numériques (2) par un convertisseur de signaux analogiques en signaux numériques (6, 7).

4. Compteur d'énergie selon une ou plusieurs des revendications précédentes, dans lequel les moyens de commutation (8) connecte chacun des premier et deuxième canaux de mesurage (101, 102) de courant alternatif et/ou continu et de tension alternative et/ou continue alternativement à la ligne d'alimentation électrique et à une source de signaux de référence pour le test d'étalonnage.

5. Compteur d'énergie selon la revendication 4, dans lequel sont prévus deux convertisseurs des signaux analogique-numérique (6, 7) connectés chacun à une entrée de l'unité de traitement (2) et ayant chacun quatre canaux de conversion, les premiers canaux de mesurage (101) respectivement pour les courants alternatif et continu et les tensions alternative et continue étant connectés aux canaux de conversion d'un premier convertisseur numérique (6) tandis que les deuxièmes canaux de mesurage (102) pour le courant et la tension alternatifs et continus étant connectés aux canaux de conversion d'un deuxième convertisseur numérique (7).

6. Compteur d'énergie selon une ou plusieurs des revendications précédentes, dans lequel chaque moyen de commutation (8) a au moins deux entrées qui peuvent être passées alternativement à un desdits premier et deuxième canaux de mesurage (101, 102) de courant et de tension alternatif et/ou continu et une entrée de ces entrées-ci est connectée à la ligne d'alimentation électrique, et la au moins une autre entrée supplémentaire à une source d'au moins un signal de référence, les moyens pour tester l'étalonnage déterminant un signal de référence mesuré par le canal de mesurage (101, 102) respectivement passé à ladite source de signal de référence et comparant ledit signal de référence mesuré au signal de référence nominale et les moyens pour effectuer l'étalonnage déterminant un paramètre de correction dudit canal de mesurage (101, 102) en fonction du résultat de ladite comparaison.

7. Compteur d'énergie selon la revendication 6, dans lequel chaque moyen de commutation (8) a au moins quatre entrées pour connecter alternativement le premier et deuxième canal de mesurage correspondant (101, 102) à la ligne d'alimentation électrique et à trois signaux de référence différents (OVref, -Vref, +Vref) l'un pour déterminer le décalage du canal de mesurage et les deux autres pour déterminer le facteur de gain du canal de mesurage, les moyens pour effectuer l'étalonnage comprenant des moyens de comparaison pour déterminer un paramètre de correction de décalage à partir de la différence entre le signal de référence de décalage mesuré et le signal de référence de décalage nominal et des moyens pour déterminer un paramètre de correction de gain à partir de la comparaison entre les signaux de référence de gain mesuré et les signaux de référence de gain nominal, chaque canal (101, 102) étant pourvu de moyens pour effectuer l'étalonnage comprenant un additionneur qui ajoute le paramètre de correction de décalage aux valeurs mesurées par ledit canal.

8. Compteur d'énergie selon les revendications 6 ou 7, dans lequel les moyens de commutation (8) ont un canal d'entrée supplémentaire pour un autre signal de référence ayant une forme d'onde sinusoïdale et une fréquence de référence pour déterminer le déphasage des mesurages de courant et de tension et compenser ledit déphasage.

9. Compteur d'énergie selon une ou plusieurs des revendications précédentes 4 à 8 dans lequel les canaux de mesurage (101, 102) mesurent des valeurs de tension, chaque canal de mesurage étant connecté à la ligne d'alimentation électrique par un convertisseur courant/tension (103), les signaux de référence (OVref, -Vref, +Vref) étant des signaux ayant une valeur de tension de référence prédéterminée.

10. Compteur d'énergie selon les revendications 7 et 9, dans lequel le signal de référence pour déterminer le décalage est un signal de 0 volt et les signaux de référence pour déterminer le facteur de gain sont des signaux ayant des valeurs de tension différentes, qui peuvent aussi être identiques, respectivement positifs et négatifs.

11. Compteur d'énergie selon une ou plusieurs des revendications précédentes 7 à 10 dans lequel
chaque moyen de commutation (8) est un multiplexeur;
chaque canal de mesurage (101, 102) est muni d'un filtre passe-bas (4) ayant l'entrée connectée à la sortie d'un multiplexeur correspondant (8) et une sortie connectée à un amplificateur différentiel (5) la sortie étant connectée à un canal respectivement d'un premier et un deuxième desdits convertisseurs analogique-numérique (6, 7) chaque convertisseur analogique-numérique étant connecté à l'entrée d'une unité de traitement (2), ladite unité de traitement étant munie de moyens pour générer un signal de commande des multiplexeurs pour actionner les multiplexeurs (8) et les moyens pour effectuer l'étalonnage étant formés par ladite unité de traitement (2) comprenant des moyens pour calculer les paramètres de correction de décalage et les paramètres de correction de gain de chaque canal de mesurage (101, 102) et ledit additionneur pour ajouter le paramètre de correction de décalage à la valeur de tension mesurée de chaque canal de mesurage (101, 102) et des moyens pour appliquer lesdits paramètres de correction de gain comme facteur multiplicateur à ladite valeur de tension mesurée.

12. Compteur d'énergie selon la revendication 11 dans lequel lesdits moyens pour effectuer l'étalonnage sont un programme exécutable chargé et exécuté par ladite unité de traitement (2).

13. Un procédé pour effectuer l'étalonnage automatique dans un compteur d'énergie selon l'une ou plusieurs des revendications précédentes dans lequel
Chacun des premiers canaux de mesurage de courant alternatif et/ou continu et de tension alternative et/ou continue et chacun des deuxièmes canaux de mesurage de courant alternatif et/ou continu et de tension alternative et/ou continue sont alternativement passés à la ligne dans laquelle la consommation d'énergie doit être mesurée et à un ou plusieurs signaux de référence, de sorte que l'un desdits premier et deuxième canaux de mesurage est soumis au test d'étalonnage et l'autre du premier et du deuxième canaux de mesurage est fonctionnel pour le mesurage de l'énergie et dans lequel
Le test d'étalonnage consiste en la comparaison entre la tension de référence mesurée par un canal de mesurage et une valeur nominale de ladite tension de référence et est effectué un certain nombre de fois dans un certain ordre temporel;
un premier signal de référence servant à déterminer un paramètre d'ajustement d'étalonnage additionnel aux signaux mesurés d'un canal;
ledit paramètre d'ajustement d'étalonnage additionnel étant déterminé par la différence des mesures de tension dudit premier signal de référence ayant une tension de référence prédéterminée avec la valeur nominale prédéterminée de ladite tension de référence,
**caractérisé en ce que**
sont prévus deux autres signaux de référence pour déterminer un paramètre d'ajustement d'étalonnage multiplicatif du signal mesuré d'un canal de mesurage, ledit paramètre d'ajustement d'étalonnage multiplicatif étant déterminé par le rapport de la différence entre les valeurs de tension mesurées desdits deux autres signaux de référence, ayant de préférence la même tension mais polarité différente, et la différence des valeurs nominales desdites tensions de référence,
l'étalonnage de chaque canal étant effectué en ajoutant ledit paramètre d'ajustement d'étalonnage additionnel aux signaux mesurés par le canal correspondant et en appliquant ledit paramètre d'ajustement d'étalonnage multiplicatif aux signaux mesurés par le canal correspondant comme gain de l'amplification du signal mesuré.

14. Un procédé selon la revendication 13, dans lequel est prévu un quatrième signal de référence pour l'étalonnage du déphasage, ce quatrième signal de référence étant une onde sinusoïdale à 50Hz alimentant alternativement chaque canal de mesurage pour compenser ainsi le déphasage des canaux de mesurage de courant et de tension par des mesurages de puissance active et réactive.

15. Un procédé pour effectuer un test pour valider la fiabilité de la procédure d'étalonnage automatique selon la revendication 13 ou 14 dans un compteur d'énergie électrique ayant au moins un couple des canaux de mesurage, lequel procédé comprend les étapes de:
Générer signaux de référence indépendants ayant chacun un paramètre de référence prédéterminé, de préférence sa tension qui est différente de l'autre;
Injecter chacun desdits signaux de référence dans un canal de mesurage du compteur d'énergie;
Acquérir le paramètre de référence mesuré pour chacun desdits signaux de référence;
calculer au moins deux paramètres d'ajustement d'étalonnage différents selon deux fonctions différentes à partir dudit paramètre de référence mesuré desdits signaux de référence et de la valeur prédéterminée desdits paramètres de référence desdits signaux de référence;
Appliquer lesdits paramètres d'ajustement d'étalonnage au canal correspondant;
Répéter ces étapes pour chaque canal de mesurage,
**caractérisé en ce que**
l'étape de génération de signaux de référence indépendants comprend la génération d'au moins trois signaux de référence indépendants (OVref, -Vref, +Vref), le procédé comprenant en outre:
déterminer pour chaque canal de mesurage une courbe caractéristique réelle calculée en appliquant lesdits paramètres d'étalonnage audit canal et une courbe caractéristique idéale en utilisant les trois signaux de référence (OVref, -Vref, +Vref);
Considérer l'étalonnage comme fiable uniquement si la différence entre la courbe caractéristique réelle et la courbe caractéristique idéale dudit canal reste à l'intérieur d'un seuil défini, sinon considérer l'étalonnage comme non fiable et générer un ou plusieurs signaux d'alarme différents et/ou une demande d'entretien/ajustement externe et/ou mettre le canal dans un état inactive.
